# EUROPEAN PATENT APPLICATION

(11) **EP 2 797 112 A1**
(43) Date of publication of application: **29.10.2014**
(21) Application number: 11878097.2
(22) Date of filing: 20.12.2011
(51) Int. Cl.: H01L 23/473, H01L 25/07, H01L 25/18, H05K 7/20

(54) **SEMICONDUCTOR MODULE**

(71) Applicant: Toyota Jidosha Kabushiki Kaisha, Toyota-shi, Aichi 471-8571 (JP)
(72) Inventor: HOTTA Koji, Toyota-shi Aichi 471-8571 (JP)
(74) Representative: Desormiere, Pierre-Louis
(86) International application number: PCT/JP2011/079559
(87) International publication number: WO 2013/094028

(57) **Abstract**

Provided is an improved cooler-integrated semiconductor module.

A semiconductor module (100) includes a plurality of cooling plates (12), and a plurality of flat-plate semiconductor packages (5) and flat-plate device packages (2). The semiconductor packages (5) each include a semiconductor element housed therein. The device packages (2) each include an electronic component housed therein, the electronic component being different in type from the semiconductor element housed in the semiconductor elements. The cooling plates (12) are laminated alternately with the semiconductor packages (5) or the device packages (2). Connecting tubes (13a, 13b) having refrigerant flowing therein are provided between the cooling plates (12) adjacent to each other.

## Description

### TECHNICAL FIELD

The present invention relates to a semiconductor module in which a cooler is integrated with a plurality of flat-plate semiconductor packages each including a semiconductor element housed therein.

### BACKGROUND ART

Semiconductor elements such as an IGBT and a reflux diode used in an inverter and a voltage converter have a large calorific value. Those elements may be called a power semiconductor element or simply a power element. The calorific value depends on a current magnitude to flow. Accordingly, the inverter for supplying an electric power to a motor for driving wheel assemblies (a drive motor for an electric vehicle including a hybrid vehicle), and the voltage converter are required to provide a large output, and use many power elements having a large calorific value. As well as the power elements, an electronic component having a large calorific value is used in the inverter and the voltage converter. A typical example of such an electronic component is a capacitor (a smoothing capacitor) for smoothing a current flowing between a source and a drain (between an emitter and a collector) of the power element. Since the current flowing between the source and the drain of the power element is large, a capacitance of the smoothing capacitor becomes large, so that its calorific value also becomes large. In view of this, there has been proposed such a semiconductor module for an electric vehicle that many power elements and other circuit elements are integrated with a cooler.

For example, Patent Document 1 describes a semiconductor module in which flat-plate cooling tubes (cooling plates), flat-plate semiconductor packages, and flat smoothing capacitors are laminated. In the semiconductor module, the semiconductor package is sandwiched in one layer sandwiched between adjacent cooling plates, and the flat smoothing capacitor is provided in another layer sandwiched between adjacent cooling plates. A flattening ratio of the smoothing capacitor is not large, and a thickness of the smoothing capacitor is thicker than that of the semiconductor package. Thus, spaces between the cooling plates thus laminated are not equal.

Further, Patent Document 2 describes a semiconductor module obtained in which a capacitor and a semiconductor element are housed in one package by molding, and a plurality of packages and a plurality of cooling plates are laminated alternately. Further, Patent Document 3 describes a semiconductor module in which a plurality of electronic components formed in a plate-like shape and a plurality of cooling plates are laminated alternately.

A device in which packages each including a semiconductor element housed therein or electronic components formed in a plate-like shape and cooling plates are laminated is able to cool off the packages or the electronic components from both sides thereof, so that the device is excellent in compactness.

### Citation List

### Patent Documents

Patent Document 1: Japanese Patent Application Publication No. 2001-320005
Patent Document 2: Japanese Patent Application Publication No. 2010-153527
Patent Document 3: Japanese Patent Application Publication No. 2007-053307

### SUMMARY OF THE INVENTION

The present specification relates to a semiconductor module in which a plurality of semiconductor packages and the other electronic components are laminated alternately with cooling plates. The present specification provides a technique to improve such a cooler-integrated semiconductor module.

A semiconductor module according to one aspect of a technique described in the present invention includes: a plurality of cooling plates; a plurality of flat-plate semiconductor packages each including a semiconductor element housed therein; flat-plate device packages; and cooling tubes. The device packages each include an electronic component housed therein which electronic component is different in type from the semiconductor element housed in the semiconductor elements. The device package may be molded by resin. The cooling plates are laminated alternately with the semiconductor packages or the device packages. In other words, the semiconductor package and the device package are sandwiched between the cooling plates adjacent to each other. In the semiconductor module, the semiconductor package and the device package have generally the same width, so that the plurality of cooling plates is disposed at generally equal intervals. The cooling tubes connect two cooling plates adjacent to each other. Refrigerant flows inside the cooling tubes from one cooling plate toward the other cooling plate.

The device package is formed by molding the electronic component by resin, and it is possible to mold the electronic component with high accuracy in terms of size in its thickness direction. On that account, the molding is convenient to be laminated with the semiconductor package by use of the cooling plates. Further, a resin mold is excellent in moisture resistance and voltage endurance characteristics. Particularly, the resin mold is excellent in voltage endurance characteristics, so that the resin mold is convenient to be placed close to the semiconductor package. The semiconductor element and the electronic component through which heavy-current flows are connected via conductive members called bus bars. The bus bar is a metal long-plate-like member having a high voltage endurance. The device package excellent in voltage endurance characteristics is also convenient to be placed close to such bus bars.

A load is added to the laminated body of the cooling plates, the semiconductor packages, and the device packages from both sides in a laminating direction, so that adherence between the cooling plates and the semiconductor packages (or the device packages) is increased. By increasing the adherence, thermal conductivity between the semiconductor package (or the device package) and the cooling plate is increased. A thickness of the semiconductor package is generally equal to a thickness of the device package, and the cooling plate may have a structure in which its thickness is changed according to the load in the laminating direction. Here, an example of the "structure in which the thickness is changed" is such that part of a side wall of the cooling plate or the cooling tube has an accordion structure or a bellows structure, and a thickness of the accordion structure or the bellows structure shrinks according to the load. As described earlier, the load is added to the semiconductor module from both sides in the laminating direction. Here, since the thickness of the semiconductor package is equal to the thickness of the device package, the thicknesses between the cooling plates are equally narrowed according to the load, thereby making it possible to prevent breakage of the cooling plates.

A typical example of the electronic component housed in the device package is a capacitor. The capacitor may be a flat wound capacitor or may be a laminated capacitor. The flat wound capacitor is cheaper than the laminated capacitor. The laminated capacitor can be formed easily to be thin in comparison with the wound capacitor.

A resin mold of the device package may be molded by potting or spraying. Differently from transfer molding commonly used for a semiconductor element, the potting or the spraying does not need to increase a temperature and a pressure of the electronic component, so that it is suitable for molding of an electronic component that does not have a high heat resistance.

The semiconductor package and the device package may be disposed adjacent to each other in one layer between two cooling plates, or may be disposed in different layers. In the first case, it is possible to shorten a length of the semiconductor module in the laminating direction. In the latter case, it is possible to reduce a width of the semiconductor module. Further, in an example of the latter case, at least one semiconductor package and at least one device package may be disposed to overlap with each other when viewed from the laminating direction. Alternatively, at least one semiconductor package and at least one device package may be disposed side by side in a lateral direction between two cooling plates adjacent to each other. In other words, at least one semiconductor package and at least one device package may be disposed side by side in a direction intersecting with the laminating direction.

It is preferable that the semiconductor element in the semiconductor package be electrically connected to the electronic component in the device package via linear bus bars. In other words, it is preferable that the semiconductor element in the semiconductor package be connected to the electronic component in the device package via the bus bars with a shortest distance. By connecting the semiconductor element to the electronic component via shortest bus bars, it is possible to reduce inductance of the bus bars. This makes it possible to reduce a surge current in switching of the semiconductor element. This leads to a decrease of switching loss of the semiconductor element.

Details and further improvements of the semiconductor module described in the present specification will be described in MODE FOR CARRYING OUT THE INVENTION.

### BRIEF DESCRIPTION OF THE DRAWINGS

[FIG. 1] FIG. 1 is a perspective view of a semiconductor module of one embodiment.
[FIG. 2] FIG. 2 is a partial sectional view of the semiconductor module.
[FIG. 3] FIG. 3 is a block diagram of a motor controller unit in which the semiconductor module is used.
[FIG. 4] FIG. 4 is a plane view of the semiconductor module of the one embodiment.
[FIG. 5] FIG. 5 is a plane view of a semiconductor module of another embodiment.
[FIG. 6] FIG. 6 is a view illustrating one exemplary connection between a semiconductor package and a device package.
[FIG. 7] FIG. 7 is a view illustrating another exemplary connection between a semiconductor package and a device package.
[FIG. 8] FIG. 8 is a view to describe an example of a production step of a flat wound capacitor (1).
[FIG. 9] FIG. 9 is a view to describe the example of the production step of the flat wound capacitor (2).
[FIG. 10] FIG. 10 is a view to describe an example of a production step of a device package including a flat wound capacitor housed therein (1).
[FIG. 11] FIG. 11 is a view to describe the example of the production step of the device package including the flat wound capacitor housed therein (2).
[FIG. 12] FIG. 12 is a view to describe the example of the production step of the device package including the flat wound capacitor housed therein (3).
[FIG. 13] FIG. 13 is a view to describe an example of a production step of a laminated capacitor (1).
[FIG. 14] FIG. 14 is a view to describe the example of the production step of the laminated capacitor (2).

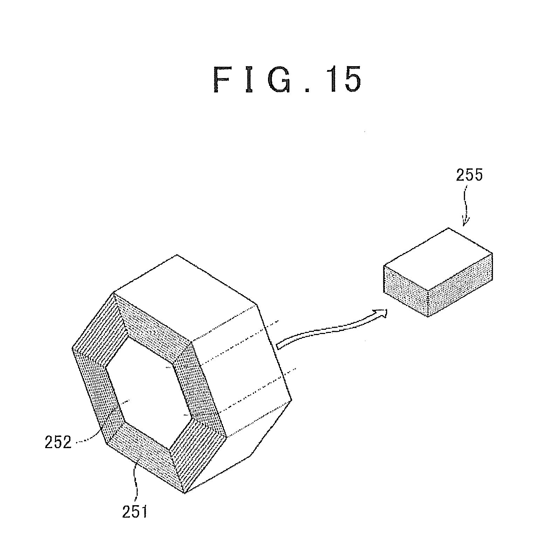

[FIG. 15] FIG. 15 is a view to describe an example of another production step of a laminated capacitor.
[FIG. 16] FIG. 16 is a sectional view of a semiconductor module of further another embodiment.
[FIG. 17] FIG. 17 is an exploded view of a cooling plate.
[FIG. 18] FIG. 18 is a sectional view of a cooling plate of one embodiment.

### MODES FOR CARRYING OUT THE INVENTION

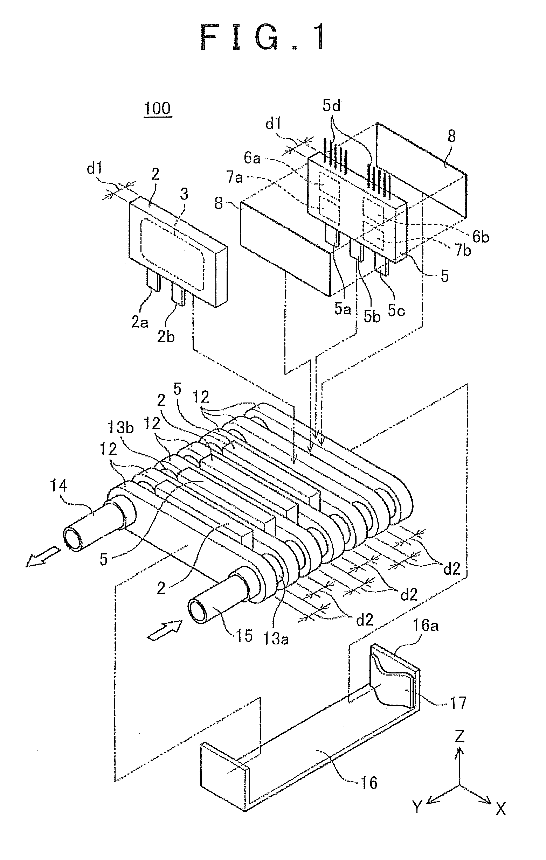

A semiconductor module according to an embodiment is described with reference to the drawings. FIG. 1 is a perspective view of a semiconductor module 100. Note that some components are illustrated separating from a main body in FIG. 1. The semiconductor module 100 is a module incorporated in a motor controller unit of an electric vehicle, and a transistor and a diode constituting a switching element of an inverter, and a smoothing capacitor are integrated therein. The semiconductor module 100 is mainly constituted by a plurality of cooling plates 12, a plurality of flat-plate semiconductor packages 5, and a plurality of device packages 2 each including a capacitor 3. Refrigerant flows inside the cooling plates 12, so that the refrigerant takes heat from the semiconductor packages 5 and the device packages 2 to cool off those packages.

The plurality of cooling plates 12 is disposed in parallel to each other, and the semiconductor package 5 or the device package 2 is sandwiched between two cooling plates 12 adjacent to each other. In other words, the semiconductor module 100 forms a laminated body in which the cooling plates 12 thus disposed in parallel to each other are laminated alternately with the semiconductor package 5 or the device package 2. A whole of the laminated body is clamped by a bracket 16. A spring 17 is incorporated between an end portion of the laminated body and a rib 16a of the bracket 16, and the spring 17 adds a pressure to the laminated body in a laminating direction. Due to the pressure of the spring 17, the cooling plate 12 adheres tightly to the semiconductor package 5 or the device package 2. Such tight adherence improves heat transfer efficiency between the cooling plate 12 and the semiconductor package 5 or the device package 2.

The cooling plates 12 adjacent to each other are connected to each other via two connecting tubes 13a, 13b. Further, a supply tube 15 for supplying the refrigerant and a discharge tube 14 for discharging the refrigerant are connected to the cooling plate 12 placed at an end portion of the laminated body. The refrigerant supplied from the supply tube 15 flows toward the cooling plate 12 on a downstream side through the connecting tube 13a. Further, the refrigerant flowing inside the cooling plates 12 flows into the discharge tube 14 through the connecting tube 13b. The connecting tubes 13a, 13b correspond to an example of cooling tubes.

In the semiconductor module 100, the semiconductor packages 5 each including a semiconductor element housed therein and the device packages 2 each including the capacitor 3 housed therein are sandwiched alternately. The semiconductor package 5 and the device package 2 have generally the same thickness d1. Accordingly, the plurality of cooling plates 12 is disposed at generally even intervals of a width d2. The width d2 between the cooling plates 12 adjacent to each other is slightly larger than the thickness d1 of the package. Note that, when the semiconductor package 5 is inserted between the cooling plates 12, a ceramic dielectric plate 8 is attached to either side of the semiconductor package 5. The dielectric plates 8 are inserted in slight gaps between the thickness d1 of the package and the width d2 between the adjacent cooling plates 12, and greases are filled therein.

The following describes the semiconductor package 5. The semiconductor package 5 is formed by molding two transistors 6a, 6b and two diodes 7a, 7b by resin thereinside. Although not illustrated herein, the transistor 6a is connected in reverse-parallel to the diode 7a inside a resin mold, and the transistor 6b is also connected in reverse-parallel to the diode 7b. A set of the transistor 6a and the diode 7a is connected in series to a set of the transistor 6b and the diode 7b. As well known, a reverse parallel circuit of a transistor and a diode is used as a switching circuit for an inverter or a voltage converter. One semiconductor package 5 corresponds to a series connection of two switching circuits.

As illustrated in FIG. 1, three electrodes 5a, 5b, and 5c extend from one side surface (a bottom face in FIG. 1) of the semiconductor package 5, and a plurality of control terminals 5d extends from another side surface (a top face in FIG. 1). The electrode 5a is connected to a positive electrode of the series connection of two switching circuits, and the electrode 5b is connected to a negative electrode (ground) of the series connection of two switching circuits. The electrode 5c is connected to a middle point of the series connection of two switching circuits. The control terminals 5d are connected to gate electrodes of the transistors.

The device package 2 is formed by sealing the capacitor 3 by a resin mold. Both electrodes 2a, 2b of the capacitor 3 extend from one side surface (a bottom face in FIG. 1) of the device package 2.

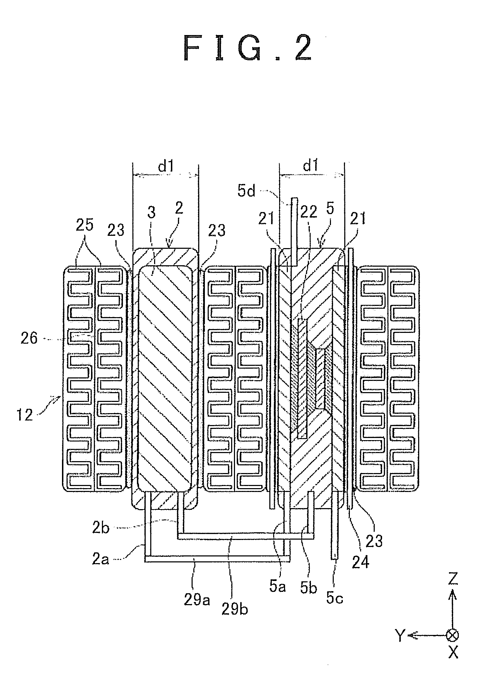

FIG. 2 illustrates a partial section of the semiconductor module 100. FIG. 2 illustrates sections of three cooling plates 12, and the semiconductor package 5 and the device package 2 sandwiched therebetween. Note that, on a bottom side in FIG. 2, a magnified view of side edges of the cooling plates is illustrated. The cooling plate 12 is constituted by two frame plates 27 constituting a housing, a partition plate 26 dividing an internal space into two parts, and a corrugated plate 25 corresponding to cooling fins.

The semiconductor package 5 is formed by molding a transistor 22 (a semiconductor element) and a diode (not shown) by resin. A heat sink 21 is provided on either side of the semiconductor package 5. The heat sink 21 diffuses heat of the transistor 22 and the diode to a surface of the package efficiently. A dielectric plate 24 is inserted between the semiconductor package 5 and the cooling plate 12, and greases 23 are filled in both sides of the dielectric plate 24. The heat of the heat sink 21 moves to the cooling plate 12 through the greases 23 and the dielectric plate 24.

The device package 2 is formed by molding the capacitor 3 by resin. The grease 23 is filled between the device package 2 and the cooling plate 12. Heat of the capacitor 3 moves to the cooling plate 12 through a resin mold and the grease 23.

One electrode 2a of the capacitor 3 which electrode 2a extends from the device package 2 is connected to the electrode 5a extending from the semiconductor package 5 via a linear bus bar 29a. The other electrode 2b of the capacitor 3 which electrode 2b extends from the device package 2 is connected to the electrode 5b extending from the semiconductor package 5 via a linear bus bar 29b.

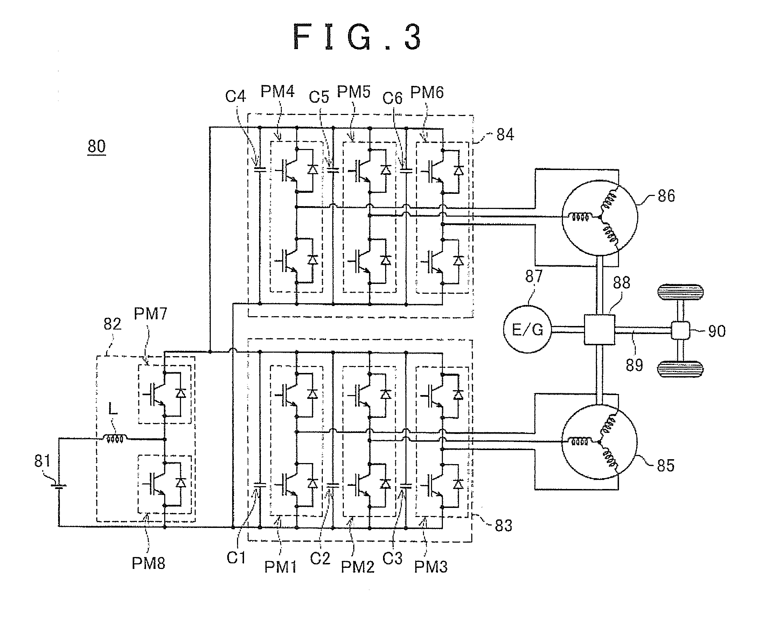

FIG. 3 is a circuit block diagram of a device to which the semiconductor module 100 is applied. FIG. 3 is a circuit diagram of a motor control unit for a hybrid vehicle 80 including an engine 87 and two motors 85, 86. The semiconductor module 100 is configured such that switching circuits of a first inverter 83 for supplying an alternating-current power to the first motor 85, switching circuits of a second inverter 84 for supplying an alternating-current power to the second motor 86, and capacitors associated with those switching circuits are integrated. The semiconductor module 100 also includes switching circuits of a boost converter 82 for converting an output voltage of a battery 81 into a high voltage suitable for motor drive. In the following description, a set of two switching circuits is called a "power module."

A circuit of the motor control unit is described below. The battery 81 is connected to the boost converter 82. The boost converter 82 is constituted by a series connection of two switching circuits, and a reactor L. The series connection of two switching circuits corresponds to a power module PM7. An output end of the boost converter 82 is connected to the first inverter 83 and the second inverter 84. As well known, a three-phase output inverter is provided with three series connections (that is, power modules) each including two switching circuits. The first inverter 83 includes power modules PM1, PM2, PM3. Respective capacitors (C1, C2, C3) are connected in parallel to the respective power modules. The second inverter 84 includes power modules PM4, PM5, PM6. Respective capacitors (C4, C5, C6) are connected in parallel to the respective power modules. A capacitor C smoothens a current flowing in a power module PM.

The following describes a drive mechanism of the hybrid vehicle 80. An output shaft of the engine 87, and output shaft of the first motor 85, and an output shaft of the second motor 86 engage with each other in a power distribution mechanism 88. The power distribution mechanism 88 is a planetary gear. The output shaft of the engine 87 is connected to a planetary carrier, the output shaft of the first motor 85 is connected to a sun gear, and the output shaft of the second motor 86 is connected to a ring gear. The ring gear is also connected to an axle 89. The axle 89 is connected to wheel assemblies via a differential 90. The hybrid vehicle 80 obtains a wheel assembly driving force by adjusting outputs of the engine 87 and the two motors 85, 86, appropriately. Further, the first motor 85 functions as a starter for starting the engine 87. Furthermore, the power distribution mechanism 88 distributes part of a driving torque of the engine 87 to the first motor 85, thereby causing the first motor 85 to generate an electric power so as to charge the battery 81. Further, the hybrid vehicle 80 is able to generate an electric power at the first and second motors 85, 86 by uses of a kinetic energy of the vehicle.

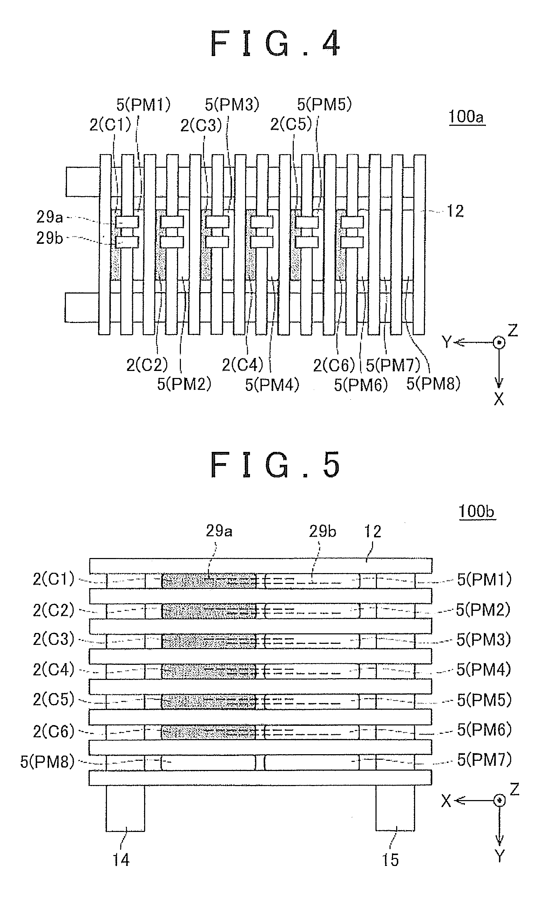

The semiconductor module 100 is configured such that seven power modules PM1 to PM7 and six capacitors C1 to C6 are integrated. One power module PM corresponds to one semiconductor package 5. Further, one capacitor C corresponds to one device package 2. Variations of a layout of the semiconductor packages 5 and the device packages 2 are illustrated in FIGS. 4 and 5. FIG. 4 illustrates a semiconductor module 100a in which device packages 2 each including a capacitor embedded therein are laminated alternately with semiconductor packages 5. The semiconductor module 100a is configured such that one semiconductor package 5 or device package 2 is accommodated in one layer between the cooling plates 12 adjacent to each other. Accordingly, the semiconductor module 100a is long in length in a laminating direction, but can be reduced in width in a lateral direction. The semiconductor package 5 and the device package 2 adjacent to each other in the laminating direction are electrically connected via bus bars 29a, 29b. FIG. 5 illustrates a semiconductor module 100b configured such that one semiconductor package 5 and one device package 2 are accommodated in one layer between cooling plates 12 adjacent to each other. One semiconductor package 5 and one device package 2 are disposed side by side in a lateral direction. The semiconductor module 100b is large in width in the lateral direction, but is reduced in length in a laminating direction. The semiconductor package 5 and the device package 2 adjacent to each other in the lateral direction are electrically connected via bus bars 29a, 29b.

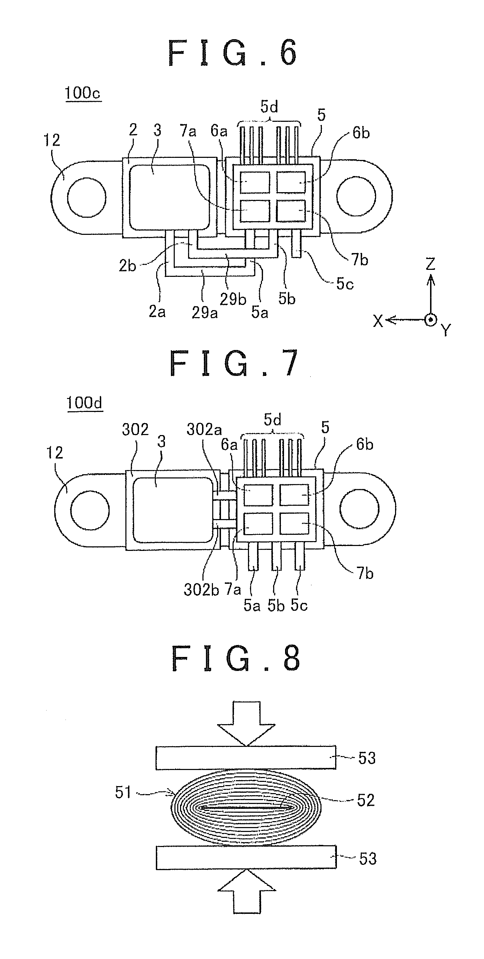

FIGS. 6 and 7 illustrate variations of wiring between the semiconductor package 5 and the device package 2 disposed side by side in one layer. FIGS. 6 and 7 illustrate a state where a mold is opened. In a semiconductor module 100c of FIG. 6, electrodes 2a, 2b of a device package 2, and electrodes 5a, 5b, and 5c of a semiconductor package 5 extend in parallel to each other toward a lateral side of a cooling plate 12. Further, the electrode 2a is connected to the electrode 5a via a linear bus bar 29a, and the electrode 2b is connected to the electrode 5b via a linear bus bar 29b.

In a semiconductor module 100d of FIG. 7, a capacitor 3 is connected to transistors 6a, 6b via linear bus bars 302a, 302b. Differently from the bus bars 29a, 29b in FIG. 6, the bus bars 302a, 302b connect the capacitor to the transistors without using the electrodes 2, 5, are shorter than the bus bars 29a, 29b.

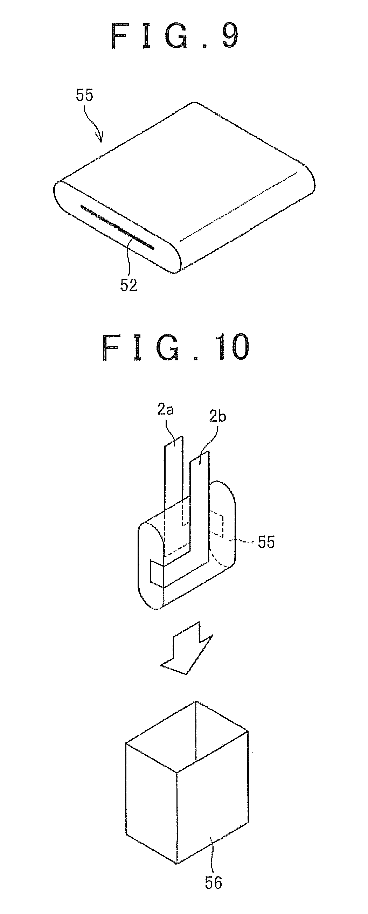

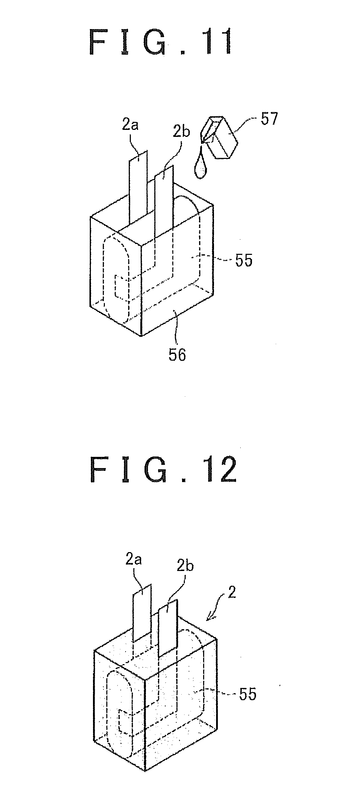

Next will be described an example of a manufacturing method of a device package containing a capacitor therein. Initially described is a device package containing a flat wound capacitor therein. As illustrated in FIG. 8, a film 51 is wound around a flat plate-like core 52 and a pressure is added thereto from both sides by use of a pair of press plates 53, so as to flatten the film 51. Hereby, a flat wound capacitor 55 is obtained, as illustrated in FIG. 9. Then, electrodes 2a, 2b are attached to the flat wound capacitor 55, and they are placed in a die 56 (FIG. 10). Subsequently, a resin 57 is poured into the die 56 (FIG. 11). This method is one example of a manufacturing method called potting. After the resin is solidified, the die 56 is removed. Hereby, a device package 2 in which the flat wound capacitor 55 is molded is obtained (FIG. 12).

As mentioned earlier, the device package 2 is manufactured by potting of resin. The potting does not need to increase a temperature and a pressure of the resin, so that it is suitable for molding of a capacitor that does not have a high heat resistance. It is also preferable to manufacture a device package 2 by resin spraying, instead of the potting.

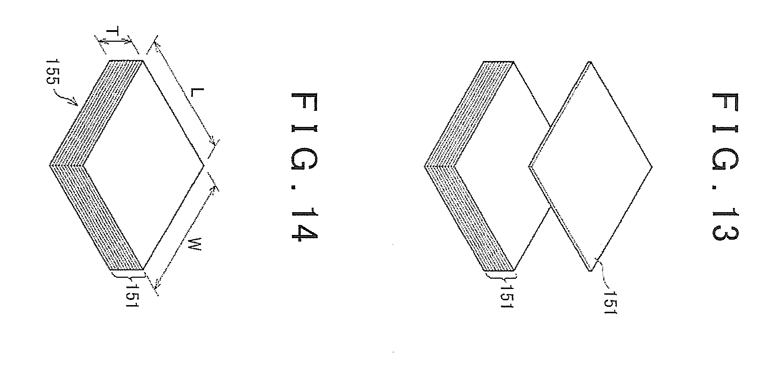

Next will be described an example of a manufacturing method of a laminated capacitor. One method is a method for laminating films 151 (FIG. 13). A laminated capacitor 155 is obtained by laminating many films 151 (FIG. 14). Another method is such that a large-sized polygonal bobbin 252 is prepared, and a film 251 is wound around the bobbin 252. When a flat part thereof is cut out, a laminated capacitor 255 is obtained. Note that it is preferable that an aspect ratio of the capacitor be 10 or more. Here, the aspect ratio indicates a ratio between a long side and a short side. When reference signs shown in FIG. 14 are used, the aspect ratio corresponds to width W/thickness T or depth L/thickness T.

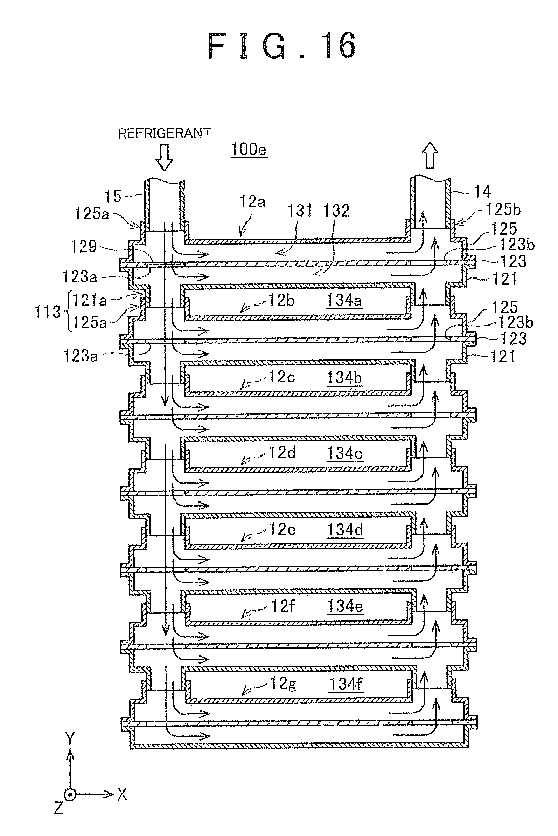

A semiconductor module 100e according to further another aspect is described. FIG. 16 is a sectional view the semiconductor module 100e. Note that FIG. 16 illustrates only a part corresponding to a cooler of the semiconductor module 100e, and a semiconductor package and a device package sandwiched between cooling plates adjacent to each other are not illustrated. The semiconductor package and the device package sandwiched between the cooling plates adjacent to each other may be the same as the case of the semiconductor module 100 of the first embodiment. The cooler of the semiconductor module 100e is constituted by cooling plates 12a to 12g. When the cooling plates 12a to 12g are called generally in the following description, they are referred to as "cooling plate 12." Note that, in FIG. 16, reference signs are assigned to individual components only in two cooling plates 12a, 12b on an upper side, but reference signs to individual components are omitted in the other cooling plates.

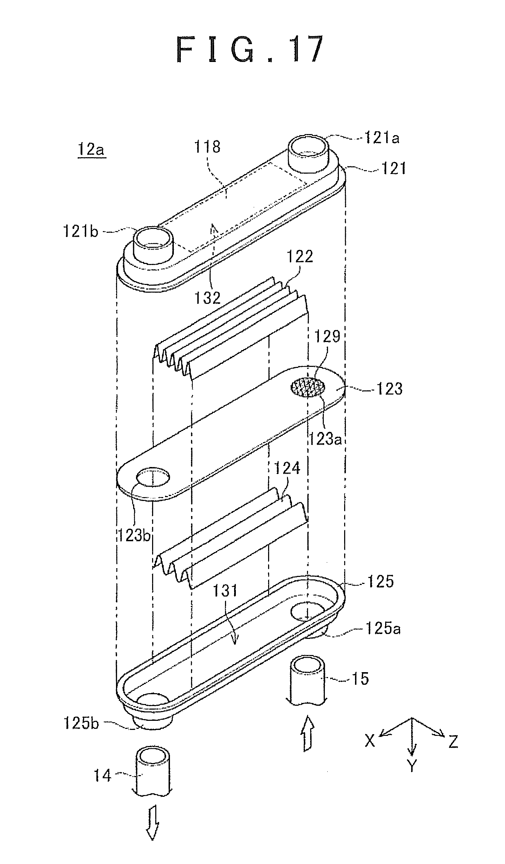

FIG. 17 is an exploded perspective view of a single cooling plate. FIG. 17 is an exploded perspective view of an outermost cooling plate 12a to which a supply tube 15 and a discharge tube 147 are connected. However, the other cooling plates also have the same structure except for a filter 129. A housing of the outermost cooling plate 12a is constituted by two opposed outer plates 121, 125. The outer plates 121, 125 have a shape of a shallow container with a flange. When the outer plates 121, 125 are joined to each other with an intermediate plate 123 being sandwiched therebetween and the flanges facing each other, the cooling plate 12a having refrigerant passages 131, 132 (see FIG. 16) therein is formed. Note that the flanges of the outer plates are joined by brazing.

Two openings 121a, 121b are formed in one outer plate 121. The openings project from a surface of the outer plate. Hereinafter, such openings may be referred to as projecting openings. Projecting openings 125a and 125b are also formed in the other outer plate 125 on both sides in its longitudinal direction (an X-direction in the figure). In the intermediate plate 123, openings 123a, 123b are also formed at positions opposed to the openings in the outer plates. The openings 121a, 123a, and 125a are provided so as to overlap with each other when viewed in a laminating direction (a Y-direction in the figure) of the cooling plates, and those openings constitute a through hole penetrating through the cooling plate 12a. Similarly, the openings 121b, 123b, and 125b constitute a through hole. The two through holes of the outermost cooling plate 12a are provided on both sides of a region 118 with which a semiconductor package abuts.

The intermediate plate 123 separates an internal space of the cooling plate 12a into two parts. In FIG. 17, since the refrigerant supply tube 15 is connected to the opening 125a of the lower outer plate 125, a bottom side in FIG. 17 corresponds to a refrigerant upstream. The intermediate plate 123 divides a passage inside the cooling plate 12a into an upstream passage 131 and a downstream passage 132.

The filter 129 for removing foreign substances is attached to the upstream opening 123a of the intermediate plate 123. The foreign substances included in the refrigerant flowing from the refrigerant supply tube 15 do not flow to the cooling plates on a downstream side relative to the outermost cooling plate 12a due to the filter 129, so that the foreign substances pass through the upstream passage 131 of the outermost cooling plate 12a so as to be discharged from the discharge tube 14.

Heat dissipating fins 124 (rough-pitch heat dissipating fins 124) extending along a flowing direction of the passage are disposed in the upstream passage 131, and heat dissipating fins 122 (fine-pitch heat dissipating fins 122) extending along a flowing direction of the passage are disposed in the downstream passage 132. The heat dissipating fins 124, 122 are provided to make it easy to transfer heat of the outer plates 121, 125 to the refrigerant, and improve cooling performance of the cooling plate 12a. A pitch of the rough-pitch heat dissipating fins 124 on the upstream side is rougher than that of the fine-pitch heat dissipating fins 122 on the downstream side. The heat dissipating fins 122, 124 are corrugated plates, and one wave corresponds to a "fin." Further, the "pitch of fins" indicates a pitch of the corrugated plate. The rough-pitch heat dissipating fins 124 having a rough pitch are placed in the upstream passage 131 so that the foreign substances are easy to flow. Since the foreign substances do not flow in the downstream passage 132 due to the filter 129, the fine-pitch heat dissipating fins 122 for increasing cooling efficiency are placed in the downstream passage 132.

Now back to FIG. 16, the following continues the description thereof. Two cooling plates adjacent to each other are configured such that the projecting opening 121a (121b) of one cooling plate is fitted to the projecting opening 125a (125b) of the other cooling plate opposed to the one cooling plate, thereby forming a connecting tube 113. The projecting opening 121a (121b) is also joined to the projecting opening 125a (125b) by brazing or the like.

As well illustrated in FIG. 16, all the cooling plates have the same structure. However, the filter 129 is provided only in the through hole of the intermediate plate 123 of the cooling plate 12a on the upstream side which through hole is close to the supply tube 15. Further, although not illustrated in FIG. 16, the rough-pitch heat dissipating fins 124 (see FIG. 17) are disposed in the upstream passage 131 of the outermost cooling plate 12a, and the fine-pitch heat dissipating fins 122 are disposed in the other passages.

Arrows in the passages illustrated in FIG. 16 indicate flows of the refrigerant. As illustrated by the arrows, the refrigerant supplied to the cooler from the supply tube 15 flows through each of the cooling plate in parallel, and goes out from the discharge tube 14. The foreign substances mixed in the refrigerant do not flow into the downstream passage 132 and the other cooling plates due to the filter 129, so that the foreign substances pass through the upstream passage 131 of the outermost cooling plate 12a and are discharged from the discharge tube 14. At this time, since not the fine-pitch heat dissipating fins 122, but the rough-pitch heat dissipating fins 124 are disposed in the upstream passage 131, the foreign substances pass through large gaps between the fins to flow smoothly.

A semiconductor package and a device package (not shown) are disposed in a space 134a between the outermost cooling plate 12a and the cooling plate 12b adjacent to this. Similarly, a semiconductor package or a device package is disposed in spaces 134b to 134f between cooling plates adjacent to each other. As described above, a laminated body of a plurality of cooling plates 12 and a plurality of semiconductor packages (or device packages) receives a compressive load in its laminating direction, so as to adhere to each other. Heat of the semiconductor package is absorbed by the refrigerant via the outer plates 121, 125 of the cooling plate 12 and the fine-pitch heat dissipating fins 122, thereby cooling off the semiconductor package.

As well illustrated in FIG. 16, no semiconductor package is disposed on an upstream side of the outermost cooling plate 2a. On this account, even if cooling performance thereof is set lower than the other cooling plates by disposing the rough-pitch heat dissipating fins 124 (see FIG. 17) in the upstream passage 131 of the outermost cooling plate 12a, it does not affect cooling performance of the semiconductor module 100e as a whole.

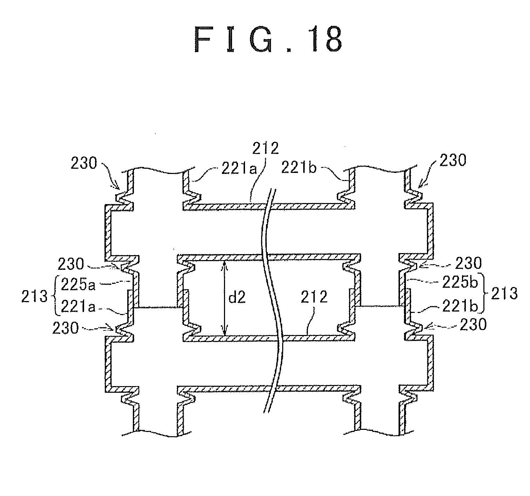

Referring now to FIG. 18, a modified embodiment of the cooling plate 12 illustrated in FIGS. 16, 17 is described. FIG. 18 is a sectional view of two cooling plates 212 connected to each other. The cooling plates 212 have openings 221a (221b) and 225a (225b) connected each other and constituting a connecting tube 213. A root of the opening 221a (221b) forms bellows 230. Similarly, a root of the opening 225a (225b) forms bellows 230. That is, the bellows 230 are provided in roots of the connecting tube 213. When a group of laminated cooling plates receives a load in a laminating direction, the bellows 230 shrink, so that a distance d2 between the plates adjacent to each other is reduced. That is, the cooling plates 212 have a structure in which the distance d2 between the plates is changed according to the load in the laminating direction. Note that, in FIG. 18, the intermediate plate 123 illustrated in FIGS. 16, 17 is not illustrated.

The following describes a point to keep in mind in regard to the technique described in the above embodiments. In the semiconductor module 100 in the above embodiments, the semiconductor package and the device package have generally the same width, so that the plurality of cooling plates is disposed at generally equal intervals. The cooling tubes connect two cooling plates adjacent to each other. According to the configuration of the embodiments, it is possible to sandwich semiconductors and the other electronic components in a semiconductor module in which distances between the cooling plates are equal to each other. Since the distances between the cooling plates are equal to each other, it is possible to use the same components for the cooling tubes provided between the cooling plates adjacent to each other, thereby making it possible to reduce manufacturing cost.

The semiconductor package of the embodiments may include a dielectric plate provided between the semiconductor element and the cooling plate. Further, the device package may include a dielectric plate provided between the electric component and the cooling plate.

The concrete embodiments of the invention have been described in detail, but these embodiments are only examples and do not limit the invention according to Claims. A technique according to Claims includes embodiments obtained by variously modifying or altering the concrete embodiments exemplified as above. Technical elements described in the present specification or the drawings exhibit a technical usability solely or in various combinations, and are not limited to combinations as described in Claims as of filing the present application. Further, the technique exemplified in the present specification or the drawings can achieve a plurality of objects at the same time, and has a technical usability by achieving one of those objects.

## Claims

1. A semiconductor module **characterized by** comprising:
a plurality of cooling plates;
a plurality of flat-plate semiconductor packages each including a semiconductor element housed therein;
flat-plate device packages each including an electronic component housed therein, the electronic component being different in type from the semiconductor element housed in the semiconductor elements; and
cooling tubes provided over the cooling plates adjacent to each other and having refrigerant flowing therein, wherein:
the plurality of cooling plates are disposed at generally equal intervals, and the semiconductor package and the device package are sandwiched between the cooling plates adjacent to each other; and
the cooling plates are laminated alternately with the semiconductor packages or the device packages.

2. The semiconductor module according to claim 1, **characterized in that**:
a thickness of the semiconductor package is generally equal to a thickness of the device package.

3. The semiconductor module according to claim 1 or 2, **characterized in that**:
the device package is molded by resin.

4. The semiconductor module according to any one of claims 1 to 3, **characterized in that**:
the electronic component housed in the device package is a capacitor.

5. The semiconductor module according to claim 4, **characterized in that**:
the capacitor is a flat wound capacitor.

6. The semiconductor module according to claim 4, **characterized in that**:
the capacitor is a laminated capacitor.

7. The semiconductor module according to any one of claims 1 to 6, **characterized in that**:
a resin mold of the device package is molded by potting or spraying.

8. The semiconductor module according to any one of claims 1 to 7, **characterized in that**:
at least one semiconductor package and at least one device package are disposed to overlap with each other when viewed from a laminating direction.

9. The semiconductor module according to any one of claims 1 to 8, **characterized in that**:
at least one semiconductor package and at least one device package are disposed side by side in a lateral direction between two cooling plates adjacent to each other.

10. The semiconductor module according to any one of claims 1 to 9, **characterized in that**:
the semiconductor element in the semiconductor package is electrically connected to the electronic component in the device package via linear bus bars.
